# EUROPEAN PATENT APPLICATION

(11) **EP 4 517 297 A1**
(43) Date of publication of application: **05.03.2025**
(21) Application number: 24196864.3
(22) Date of filing: 28.08.2024
(51) Int. Cl.: G01N 17/02, G01N 27/20

(54) **HOLIDAY DETECTION AND DATA STORAGE**

(30) Priority: 29.08.2023 US 202363535136 P; 26.08.2024 US 202418815411
(71) Applicant: Pipeline Supply and Service LLC, Houston TX 77038 (US)
(72) Inventor: Campbell, James Jeffery, Houston, 77038 (US); Brooks, Ronald Dean, Houston, 77038 (US)
(74) Representative: Garavelli, Paolo

(57) **Abstract**

A method and apparatus for traversing the length of a conductive substrate - in the form of a pipeline - with a holiday detector, inducing an arc voltage at a defect of a coating disposed on the conductive substrate, detecting the arc voltage with sensors, and recording an electrode voltage with electronics disposed at the holiday detector.

## Description

### BACKGROUND

The present application claims priority to U.S. Provisional Patent Application No. 63/535,136, filed August 29, 2023, the entire disclosure of which is incorporated herein by reference.

### BACKGROUND

Pipelines are often used to carry various materials including crude oil, refined petroleum, liquified petroleum gas, natural gas, water, hydrogen, slurries, and the like. The pipelines are typically disposed above or below ground and are subject to corrosion by corrosive substances such as water present in the natural environment. To address this issue, industrial practices usually involve applying a protective coating to the external surface of the pipelines to limit the exposure of the naked pipelines to these corrosive substances.

One problem is that defects (e.g., voids, pinholes, bubbles, thinning of the protective coating, foreign particulates, etc.) may be present in these protective coatings. These defects may defeat the purpose of the protective coating by providing the corrosive substances with an access point to the underlying pipeline, thus allowing the corrosion to occur. Premature corrosion of a pipeline reduces its lifetime expectancy resulting in increased cost.

To detect these defects, handheld high voltage [e.g., at least 1 kilovolts (kV)] spark generators, commonly referred to as holiday detectors are used. These devices are often used to probe the outer surface of conductive substrates (e.g., pipelines) by applying a voltage to the outer surface with an electrode and connecting the conductive substrate to a ground cable. When the electrode is applied to the protective coating, the protective coating acts as a dielectric material and prevents current from flowing into the conductive substrate, however when it is applied to an area in the vicinity of a defect, current flows from the electrode to the conductive substrate, resulting in a short circuit and thus an arc voltage or "spark." This arc voltage is detectable and may be used to estimate the general location of the defect. Once found, the area hiding the defect is typically marked by hand by an operator and then sandblasted, and a new layer of protective material (e.g., referred to as patch) is applied to the area to prevent future corrosion and thus promote the desired longevity of the conductive substrate.

Holiday detectors are generally only able to identify the location of the defects on the longitudinal axis (x-coordinate) of these conductive substrates. Moreover, the data corresponding to the location of the defects and other data is recorded by hand and thus subject to human error.

### BRIEF DESCRIPTION OF THE DRAWINGS

These drawings illustrate certain aspects of some of the embodiments of the present invention and should not be used to limit or define the invention.
FIG. 1 illustrates a system for detecting one or more defects in a protective coating of one or more conductive substrates in accordance with examples of the present disclosure.
FIG. 2 illustrates an electronics configuration for collecting and storing data in accordance with examples of the present disclosure.
FIG. 3 illustrates a workflow for counting defects in accordance with examples of the present disclosure.
FIG. 4 illustrates a smart electrode in accordance with examples of the present disclosure.
FIG. 5 illustrates an electronics configuration for smart detection of defects using a rotating coupling housing in accordance with examples of the present disclosure.

### DETAILED DESCRIPTION

Disclosed herein are techniques [systems, apparatuses, and methods] for the detecting of defects within a dielectric coating on a conductive substrate. Aspects may include techniques that provide for the localizing [locating] of the defect(s) within a protective coating on a conductive substrate, e.g., of a pipeline, as well as techniques for collecting, storing, and accessing data corresponding to the detected defect(s).

In implementations, the present techniques may include a detector, an electrode (e.g., a conductive coil), a ground wire, and electronics to localize [locate] defects in a protective coating on a conductive substrate, e.g., a pipeline. The detector can be labeled as a spark generator in a sense of applying a voltage to the electrode that results in a spark between the electrode and the conductive substrate at a defect in the protective coating. The systems, and apparatuses, and methods of the present disclosure may also include or involve electronics for collecting, storing, and in some examples, transmitting data associated with the location of the defects as well as other data associated with the detection of the defects and operating of the detector. Advantages of the present techniques may include, for example, the ability to detect the circumferential location of a defect in addition to its longitudinal location on a conductive substrate (for instance, a pipeline), the ability to perform defect detection with reduced personnel (e.g., a single person), the ability to collect, store, and transmit data relating to the location [e.g., Global Positioning System (GPS) data] of a defect and/or an operator technician. Benefits may further include ability to sense, store, and transmit data relating to other sensing parameters taken before, during, and/or after detection of a defect. Such date may relate to the velocity of an operator (technician), relate to the ground cable, relate to battery voltage, relate to internal temperature of an electric housing (e.g., detector housing), relate to electrode voltage (the voltage applied to an electrode), relate to a deadman handle switch (deadman switch), and so on. Other advantages include, for example, an ability to accurately count utilizing electronics the number of defects and to store and transmit this information.

As the electrode (e.g., a conductive coil) is moved across the surface of non-conductive coating and when a defect in the coating is located, the user (operator, technician) may move the electrode back and forth over the defect area to confirm presence (detection) of the defect. This process of moving the electrode back and forth over the defect area may be beneficial to pinpoint the location of the defect. Once the defect is located, the defect may be marked for repair.

The moving of the electrode forward and backward over the defect may generally create (cause or result in) a spark (arc) each time through the flaw (defect) to the conducting substrate. Conventionally, in this situation, each of the sparks created will be counted as a defect when only one should be considered a valid defect. To alleviate this problem, embodiments herein provide for a pause or inactive status. Embodiments may program electronics (e.g., including a processor and memory story code executable by the processor) of a detector (e.g., holiday detector) to apply a pause function (giving an inactive status of counting). The electronics may be, for example, in a detector housing or smart electrode housing.

When a defect is first detected in a coating, the detector may indicate (e.g., audible) detection of the defect and count the defect. As the defect is indicated and counted, the detector may pause (temporarily suspend) counting of defects and display an indication (e.g., "PAUSE") of such. This defect is counted as a valid defect and a counter (e.g., defect counter) will increment by 1. During the pause or inactive status, functions of the detector remain operational but with the counting of defects (incrementing of the counter) momentarily suspended. Any high voltage sparks (arcs) that occur in this pause condition will not be counted.

During the pause condition, the user can identify the location of the defect and mark the defect. Then, after the user has ended the pause to resume counting (e.g., by selecting or depressing an "Enter/Select/Resume" button), the detector unit may indicate (e.g., display "RESUME INSPECTION") that counting is resumed and the user can continue to inspect a coating in a normal manner. Thus, the detector may receive user input to end the pause status and resume counting. When the next defect is detected, the scenario is repeated. In other words, for this next defect, the detector indicates (e.g., audible such as a horn) the detection, increments the counter by 1, and indicates pause (e.g., "PAUSE"). The detector again resumes counting when receiving user input to resume counting. This scenario may continue to repeat with each defect found.

In implementations, each resuming of the counting by the user (e.g., by the user depressing the detector "Resume" button) may also be counted with a resume counter. In implementations, once the inspection has been completed, both the defect counter and the resume counter should generally be equal resulting in a valid defect count.

A flaw (defect) in the coating can leave the substrate poorly protected, or in some cases completely exposed. These flaws may be referred to as holidays, discontinuities, pinholes, etc. and are often very small or invisible to the naked eye. Thus, flaw (defect) detectors may be beneficial. In the relevant art, a holiday may be a discontinuity in coating, an area of insufficient coating film thickness, a pinhole or crack within the coating, an improper adhesion or bonding of the coating, and so forth.

It should be understood that while the present disclosure focuses primarily on detecting and localizing of defects within protective coatings of pipelines, the principles taught herein may apply to detecting and localizing of defects within other forms of dielectric coatings, for example, protective coatings on flat roofs, rail cars, oil storage tanks, any suitable conductive substrate, and the like, without departing from the spirit and scope of the disclosure.

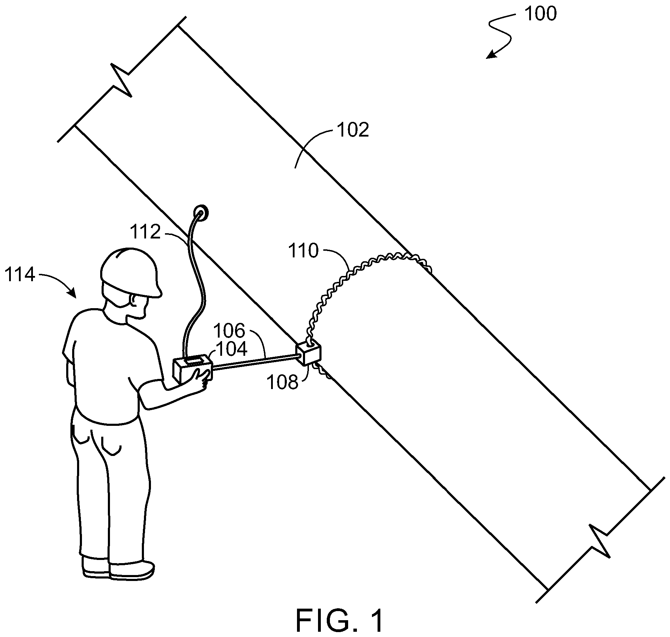

FIG. 1 illustrates a system 100 for detecting defects in a protective coating on a conductive substrate of a pipeline 102 in accordance with examples of the present disclosure. The pipeline 102 may generally be a conduit (e.g., metal) that is electrically conductive and in which a protective coating (generally not electrically conductive) is on an external surface of the conduit. The coating may be protective, for example, in protecting against external environmental corrosion of the pipeline 102. Thus, a technique to provide protection is to coat the surface of a conductive material with a non-conductive material that creates a barrier. The protective coatings may be, for example, thin film epoxy, thick coal tar, and other materials.

The protecting coating may be applied to the external surface of the pipeline 102, for example, by spraying or brushing. As the coating is applied to the surface, defects can become prevalent due, for instance to the lack of cleanliness of the surface, dust, moisture, inclusions, pinholes, thinning of coating, oil or grease, and other debris. These defects should be located and removed, and the protective surface coating reapplied, for instance, to maintain the life expectancy of the pipeline 102.

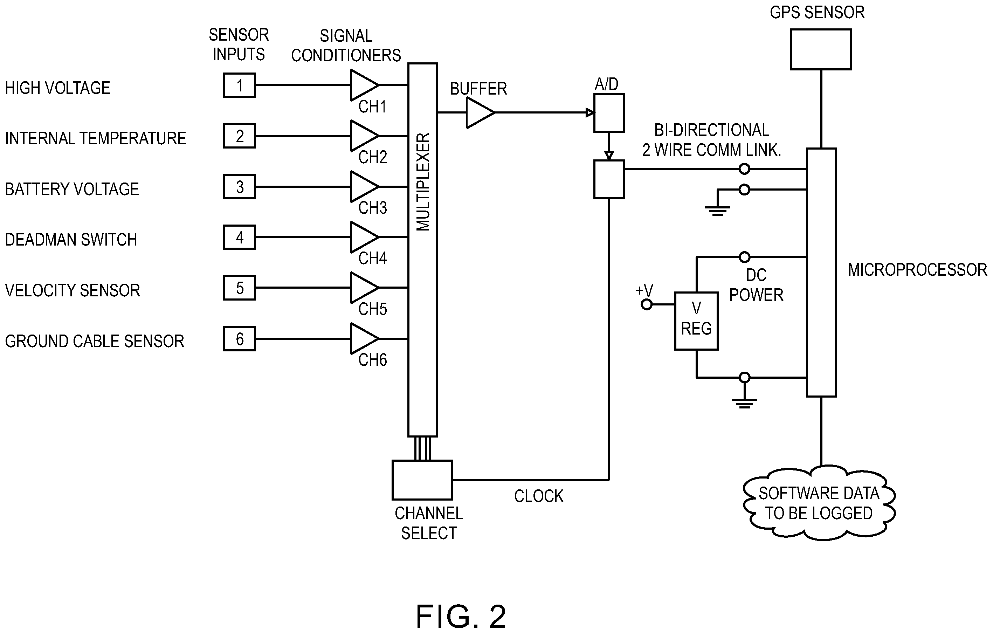

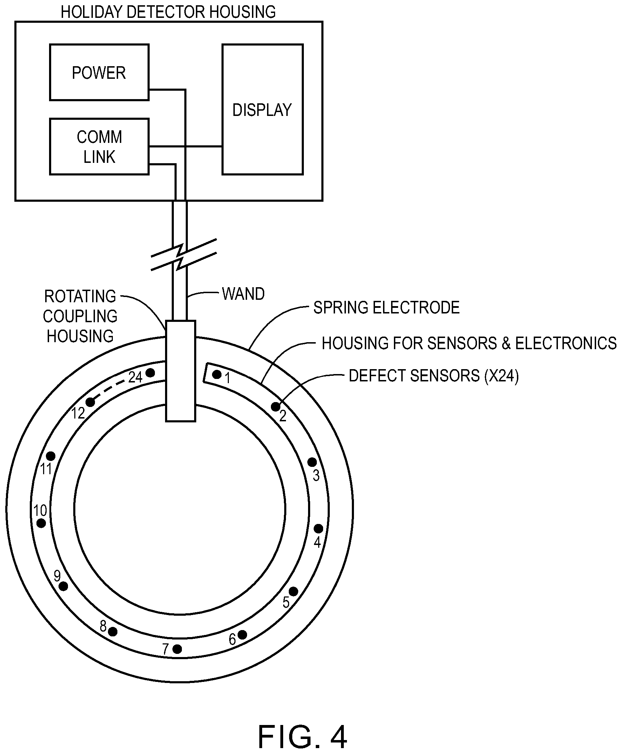

As illustrated, the system 100 may include a detector 104 (e.g., holiday detector) connected to a conductive coil 110 (e.g., an electrode such as a spring electrode) by a wand 106. The detector 104 may have a housing and be coupled to a power source. In operation, the detector 104 may act as a spark generator in applying a voltage to the conductive coil 110 that causes a spark between the conductive coil 110 and the pipeline 102 conduit (e.g., metal that is electrically conductive as a conductive substrate) at a defect in the protective coating on the pipeline 102 conduit. The detector 104 may include sensors (see, e.g., FIG. 2) inside the detector 104 housing to sense or detect a defect in the protective coating. The detector 104 may include electronics generally in the detector 104 housing. For instance, the detector 104 may include a hardware processor (e.g., microprocessor) and memory storing code (logic, instructions) executable by the processor. The positions of the located defects may be saved (stored) in detector 104 memory as collected during operation, and then downloaded from the memory to other computers. In implementations (e.g., FIG. 4), certain electronics may be situated in a housing of the conductive coil 110 giving the conductive coil 110 as a smart electrode.

A rotatable coupling 108 may facilitate the conductive coil 110 to rotate to traverse (e.g., longitudinally traverse) the pipeline 102. As indicated, in operation, a high voltage is applied to the conductive coil 110 by a power source (e.g., a battery) energetically coupled to conductive coil 110 via the detector 104. This voltage may be labeled as the electrode voltage or the inspection voltage. The power source may be, for example, a battery (e.g. attached to the detector 104 and carried by an operator).

An operator 114 (technician) holding the detector 104 may walk along pipeline 102 to apply forward movement to the wand 106 and thus the conductive coil 110. The detector 104 is additionally electrically coupled to the pipeline 102 via a ground cable 112. Encountering a defect with the conductive coil 110 amounts to the completion of a circuit between the power source, the conductive coil 110, the pipeline 102, and the ground cable 112 resulting in an arc voltage (a spark) between the conductive coil 110 and the pipeline 102. In some examples, the spark may be audibly detectable by the operator 114 if the voltage differential between the conductive coil 110 and the pipeline is high enough. The system 100 includes electronics configured to detect the spark and may further include hardware to sound an alarm (or provide a visible indication) intended to alert an operator of the defect based on detecting of the spark. The system 100 may include electronics for counting defects, collecting, and storing data, transmitting data, and detecting circumferential location of the defect, to be discussed later in detail. These electronics may be disposed within a housing of the detector 104 and may include a processor(s) and memory.

FIG. 2 illustrates an electronics configuration including a data collection and storage module for collecting and storing data in accordance with examples of the present disclosure. Data collection and storage module may include sensors that may be positioned, for example, within the housing of detector 104. The sensors may include, for example, one or more voltage sensors, one or more temperature sensors, one or more battery voltage sensors, one or more deadman switches, one or more velocity sensors (e.g., accelerometers, inertial measurement units, gyroscopes, etc.), one or more ground cable sensors, and any combinations thereof. Ground cable sensors may be employed to detect voltage or current of the ground cable 112. The electronics including the sensors may be utilized to monitor electrical properties, such as voltage (e.g., electrode voltage), current, impedance, capacitance, inductance, resistance, etc.), of various components of system 100 or changes to the electrical properties thereof. As illustrated in FIG. 2, sensor inputs may be relayed to a multiplexer via a plurality of signal conditioners. Signals may be multiplexed by a multiplexer and relayed to a buffer. The electronics may run on a clock and be configured to assign a timestamp to the signals from one or more sensors. A timestamp may be used by a processor(s) (e.g., microprocessor) to track and order events, synchronize data, log measurements, perform data analysis, analyze events (e.g., spark) as well as perform various other time-related operations.

As illustrated, a bi-directional two wire communication link may be used to link one or more microprocessors to the multiplexer. GPS data from one or more GPS sensors may also communicate GPS sensor data to the one or more microprocessors, which may be further used to interpret the multiplexed signals. Data collected and stored by the data collection and storage module may be transmitted via one or more transmitters, for example, to an external computing environment, such as an external or virtual server. The external computing environment may include software configured to further process and/or display data output by the one or more microprocessors or data derived from data output by the one or more microprocessors. The data may be displayed on any suitable display medium, for example, a smart phone application, a tablet, computer, or any suitable device configurable to run, for example, a graphical user interface. The data may be accessible in real time or substantially real time, and in some examples, may be used to inform external personnel about various operational parameters associated with operation of the detector 104. As described herein, "real time" may be generally understood to relate to a system, apparatus, or method in which a set of input data is processed and available for use within 100 milliseconds (ms). In further examples, the input data may be processed and available for use within 90 ms, within 80 ms, within 70 ms, within 60 ms, within 50 ms, within 40 ms, within 30 ms, within 20 ms, or any ranges therebetween. In some examples, real-time may relate to a human's sense of time rather than a machine's sense of time. For example, processing which results in a virtually immediate output, as perceived by a human, may be considered real time processing.

Operational parameters may include, without limitation, longitudinal/circumferential location of one or more detected defects, metrics associated with an operator's speed, battery voltage, electrode voltage that is voltage of an electrode (e.g., conductive coil 110, referring to FIG. 1), temperature, activity or lack thereof by an operator, ground cable voltage, a spark, time of spark, coating thickness, serial number of detector 104, total hours in operation, pipe inner diameter (ID) or pipe serial number, start and/or end time, time of test completion, number of defects, time-related information thereof, any combinations thereof, and/or the like. These operational parameters may, in some examples, comprise or form part of data being logged and/or timestamped by holiday detector 100.

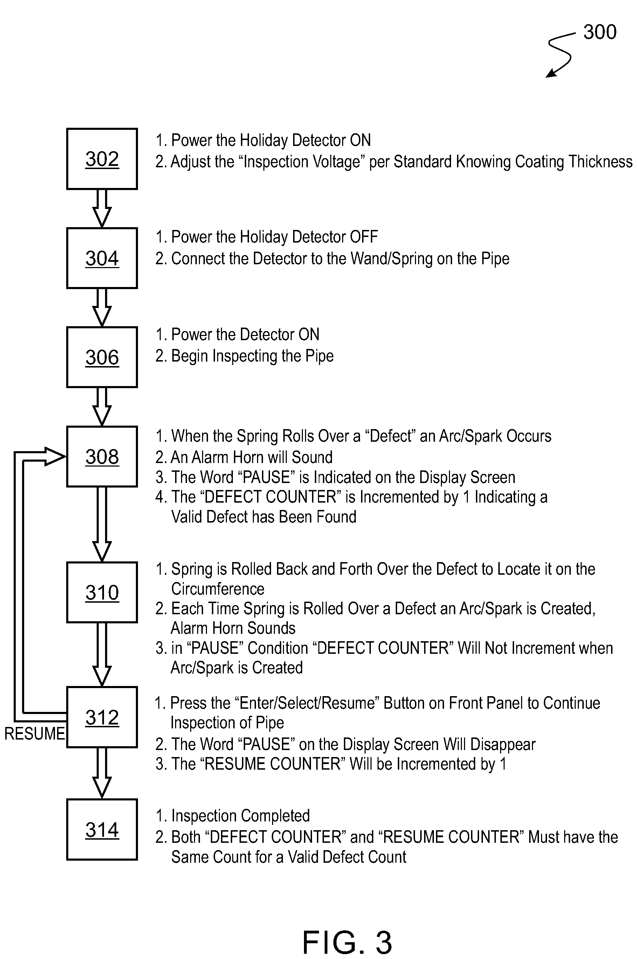

FIG. 3 illustrates a workflow 300 for counting defects in accordance with examples of the present disclosure. As illustrated, workflow 300 may begin in block 302 by turning on detector 104 (e.g., referring to FIG. 1). The detector 104 may be a holiday detector. Block 302 may include adjusting a voltage setting (e.g., inspection voltage) of the detector 104. The voltage setting may be a pre-known, standard setting based on a pre-established thickness coating and as a high voltage can be, for example, at least 1 kV. The high voltage applied to the conductive coil (electrode) can be referred to as inspection voltage or electrode voltage. The electrode voltage may physically create or result in the arc voltage. An arc physically occurs when the high voltage applied to the conductor coil passes over a defect. The arc occurs between the conductor coil and the metal substrate.

The workflow 300 may proceed by turning off detector 104 in block 304 and connecting detector 104 to a wand 106 and conductive coil 110. The workflow 300 may proceed by turning detector 104 on in block 306 and beginning to inspect the pipeline 102.

The workflow 300 may proceed by encountering a defect in block 308 when the conductive coil 110 rolls over the defect and completes the circuit, thereby causing a spark. Block 308 may include sounding of an alarm, such as a horn (e.g., air horn, piezoelectric horn, klaxon horn, various electronic horns, etc.), for example, or by flashing one or more light emitting diode (LEDs), vibrating a handheld portion of detector 104, or alerting an operator of the defect in any suitable manner. One or more instructions may appear on a display indicating the event, such as instructions to pause inspection of the pipeline 102. Displaying of instructions and/or information to an operator may be performed using a graphical user interface, such as by displaying information on a screen electronically connected to a device comprising one or more processors (e.g., computer). Block 308 may update a defect counter (e.g., by electronics of the detector 104) by an increment of one to indicate finding of a defect.

The workflow 300 may proceed in block 310 where, in some examples, conductive coil 110 is rolled back and forth (e.g., two, three, or four times) over a defect to verify or further localize the defect, such as by narrowing down the location of the defect to a specific circumferential and/or longitudinal coordinate of the one or more conductive substrate, e.g., pipeline 102, such as within a range of about 5 degrees or less from the defect relative to a central axis of pipeline 102. Electronics within the holiday detector may be configured to refrain from updating the defect counter after re-rolling over a previously detected or measured defect, such as while the apparatus is in a pause condition, as discussed.

The workflow 300 may proceed in block 312 where an operator may interact with a user interface, such as a button on a panel or software application, to continue inspection. This may end the pause condition and resume an active condition so that further defects are counted by the defect counter. Instructions displayed on a graphical user interface may change based on the interaction between the operator and the user interface, such as by removing of a previous instruction (e.g., the word "pause"). A resume counter may increase by an increment of one based on the interaction of the operator with the user interface. The workflow 300 may include repeating one or more operations of blocks 308, 310, and 312 until an operator has traversed a target length of the pipe, or until an operator indicates to the user interface of the end of the operation. The workflow 300 may proceed in block 314 where inspection may terminate. Determination of a completion status may be dependent, at least in part, upon a comparison between the defect counter and the resume counter, for example, by requiring that the defect counter and the resume counter have the same count.

FIG. 4 is a system including a smart electrode in accordance with examples of the present disclosure. The electrode may be a "smart" electrode in having sensors and electronics. A dumb conductive coil plus being equipped with electronics and sensors can give a smart conductive coil. The smart electrode can be considered part of the holiday detector but instead the smart electrode is generally in addition to the holiday detector?] The smart electrode can be unique from the holiday detector. The holiday detector may provide power and communication to the smart electrode to be able to interpret the information from the smart electrode.

A smart electrode may be attached to a holiday detector housing (e.g., the detector 104 of FIG. 1) via, for example, a wand (e.g., wand 106) and a rotating coupling housing (e.g., rotational coupling 108). The smart electrode may include a conductive coil 110 (e.g., referring to FIG. 1) which may be operable to apply pressure to pipeline 102 based on the intrinsic ability of the conductive coil to elastically deform. The smart electrode may house sensors and electronics disposed within or on conductive coil 110. As illustrated, the sensors and electronics may be disposed within a body of conductive coil 110. The sensors and electronics may include defect detectors (e.g., in the range of 2 to 200 detectors as defect detectors, or any ranges therebetween, for example, in the range of 20 to 50 defect detectors). The detectors can be labeled as sensors or defect sensors. A configuration and utilization of a plurality of detectors in this manner may, in some examples, facilitate localizing of the location of a defect to a specific circumferential coordinate of the pipeline 102. The defect detectors of the smart electrode are in addition to the detector 104.

The detectors (including sensors) may be spaced within a housing such that they are spaced circumferentially around the outer diameter when placed on pipeline 102. Spacing of the detectors may be such that each detector is approximately an equal distance apart from one another. Spacing in this manner may facilitate the localizing of a location of a defect to a specific circumferential coordinate in addition to any longitudinal coordinate of the pipeline 102.

The sensors and electronics include, for example, voltmeters, capacitors, and/or resistors, and the like. Alternatively, any suitable sensor for measuring the electric property of the spring may be implemented. Sensor inputs may be relayed to electronics disposed within a housing of detector 104, for example, via the wand. As discussed previously, electronics disposed within a housing of detector 104 may include one or more processors and memory operable to collect, store, and in some examples, transmit sensor measurements or data derived therefrom, such as to an external computing environment to be further processed (e.g., using software). This data may be displayed in the manner previously described, such as on a graphical user interface of a handheld computation device. Sensor inputs may, in some examples, be multiplexed by a multiplexer before and/or after rotation coupling housing 108. The sensors and electronics may further include electronics for measuring a time stamp of a sensor input, a buffer, multiplexer, a bi-directional two-wire communication link, an angular position sensor, any combinations thereof, and the like. Data displayed on a graphical user interface may include, for example, precise circumferential location of a detected defect.

In one or more examples, a fluid may be disposed within an inner housing disposed within conductive coil 110 (e.g., referring to FIG. 1). One or more of the defect detectors may be disposed within the fluid. The fluid may be, for example, an electrically conductive or a dielectric liquid. In some examples, the fluid may be selected based on its resistivity. Nonlimiting examples of suitable fluids to be used may include oil-based fluids, aqueous fluids, or the like. Configuration and use in this manner may, in some examples, facilitate localizing the location of a defect to a specific circumferential coordinate of pipeline 102.

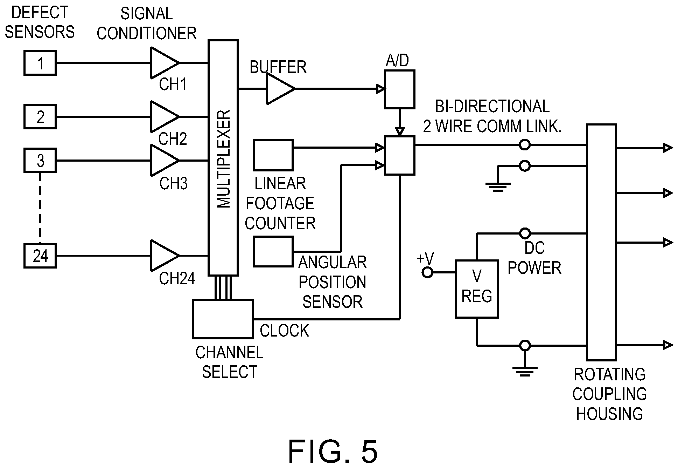

FIG. 5 is an electronics configuration for smart detection of defects using a rotating coupling 108 (e.g., referring to FIG. 1) housing in accordance with examples of the present disclosure. The FIG. 5 electronics may be disposed, for example, in the smart electrode housing and/or the rotating coupling 108 housing. The rotating coupling 108 can be, for example, a mechanical slipring or a magnetic coupling. This offers a technique of providing power and a bidirectional data communication path between the detector 104 (e.g., of FIG. 1) (such as a holiday detector) and the smart electrode (e.g., FIG. 5). The rotating coupling 108 could have electronics in its housing, for instance if of the magnetic coupling type.

As illustrated, the electronics configuration may include a plurality of defect sensors and signal conditioners, one (or more) multiplexer(s), a buffer, a linear footage counter, an angular position sensor, a clock, a channel select device, a bi-directional two-wire communication link, a DC power source, and a voltage regulator. The voltage regulator may convert the unsteady, sudden change in voltage due to a spark to a steady and stable output voltage. This may protect the electronics from potential damage caused by overvoltage. The angular position sensor may be positioned so as to localize a defect to within 5 degrees of the defect. Alternatively, within 10 degrees of the defect, within 15 degrees of the defect, or within 20 degrees of the defect. The number of defect sensors distributed throughout the spring varies inversely with the uncertainty of the circumferential position of the defect on the conductive substrate, e.g., pipeline. Depending on the diameter of the conductive substrate, a greater or smaller number of detectors and/or length of the spring may be required. The multiplexer may multiplex a plurality of signals into a single waveform which may be interpreted directly by a processor or de-multiplexed by an additional multiplexer before being processed. The buffer may serve to tone down the signals of the defect sensors, or alternatively, may be replaced by an amplifier to ensure that weaker signals are communicated. As with a previous figure, the signals of the sensors and/or data relating to measurements thereof may be collected, stored, transmitted, processed using software, displayed on a user interface [e.g., graphical user interface (GUI)], and/or uploaded to a server to be accessed in real-time, for example.

An embodiment is method of detecting a defect in or of a coating on a conductive substrate, including traversing a length of the conductive substrate with a holiday detector. The holiday detector has a housing and a spark generator disposed in the housing. The method includes inducing, via the spark generator and an electrode, an arc voltage at the defect of the coating on the conductive substrate. Further, the method includes detecting the arc voltage with a sensor associated with the holiday detector, thereby detecting the defect. The method includes recording with electronics of the holiday detector an electrode voltage (a numerical value of the electrode voltage) of the electrode. The electrode voltage is associated with the arc voltage. The electrode voltage (e.g., applied voltage, inspection voltage) may be characterized as associated with the arc voltage is that the electrode voltage (e.g., conductive coil voltage as an inspection voltage) may cause or result in the arc voltage. As discussed, an arc (spark) occurs when the voltage (e.g., high voltage) applied to the electrode (e.g., conductor coil) passes over a defect in the coating. The arc occurs between the electrode and the conductive substrate (e.g., metal substrate).

The electronics of the holiday detector may include a microprocessor and memory. The electronics may include a signal conditioner, a multiplexer, a voltage regulator, an analog to digital converter, and a GPS sensor. The method may include recording (e.g., numerical values), with the electronics, internal temperature of the housing, GPS location, battery voltage, and voltage of a ground cable. The method may include recording, by the holiday detector, velocity of the traversing (e.g., recording numerical values of the velocity), and transmitting the velocity (e.g., the numerical values) as recorded from the holiday detector to an external computer system. The method may include transmitting the electrode voltage (e.g., numerical values of the electrode voltage) as recorded from the holiday detector to an external computer system, and displaying data associated with the arc voltage on a graphical user interface of a display device of the holiday detector or of the external computer system, or both. In implementations, the sensor is disposed in the housing.

The electrode may include a conductive coil situated on the coating during the traversing of the conductive substrate. The electrode may include an electrode housing, wherein the sensor is disposed in the electrode housing. The sensor may be a plurality of sensors to detect the arc voltage. The conductive substrate having the coating may be a conduit (e.g., pipeline). The detecting of the defect may include detecting a longitudinal location of the defect along the conduit and a circumferential location of the defect around the conduit. The method may include (1) incrementing, by the electronics, a counter in response to detecting the defect, (2) pausing, by the electronics, the incrementing of the counter in response to the incrementing the counter for the defect, and (3) resuming, by the electronics, the incrementing of the counter for another defect of the coating in response to user input, wherein the another defect is at a different location than the defect.

Another embodiment is a system to traverse the length of a conductive substrate to detect a defect of a coating on the conductive substrate. The system includes a detector including a spark generator to induce an arc voltage via a conductive coil at the defect of the coating on the conductive substrate. The system includes a wand to couple the detector to the conductive coil. The system includes the conductive coil as an electrode. The system includes a sensor to detect the arc voltage to detect the defect, and electronics comprising a processor and memory to record detection of the defect in the memory. In implementations, the electronics may be disposed in a housing of the detector. The system may include a rotating coupling connecting the wand to the conductive coil. The electronics may be configured to increment a counter in response to the detection of the defect by the system and pause incrementing of the counter until user input is received to resume incrementing of the counter for another defect of the coating.

The conductive substrate having the coating may be a conduit. The conductive coil may be configured to be situated around a circumference of the conduit and moved longitudinally along the conduit (moved along a longitudinal axis of the conduit). The sensor may be a plurality of sensors spaced apart in a housing along the conductive coil to detect the arc voltage to detect the defect. The electronics and the plurality of sensors may be configured to determine a longitudinal location of the defect along the conduit and a circumferential location of the defect around the conduit.

It is to be understood that the present disclosure is not limited to particular devices or methods, which may, of course, vary. It is also to be understood that the terminology used herein is for the purpose of describing particular embodiments only, and is not intended to be limiting. All numbers and ranges disclosed herein may vary by some amount. Whenever a numerical range with a lower limit and an upper limit is disclosed, any number and any included range falling within the range are specifically disclosed. Although individual embodiments are discussed herein, the invention covers all combinations of all those embodiments. As used herein, the singular forms "a", "an", and "the" include singular and plural referents unless the content clearly dictates otherwise. Furthermore, the word "may" is used throughout this application in a permissive sense (i.e., having the potential to, being able to), not in a mandatory sense (i.e., must). The term "include," and derivations thereof, mean "including, but not limited to." The term "coupled" means directly or indirectly connected. If there is any conflict in the usages of a word or term in this specification and one or more patent or other documents that may be incorporated herein by reference, the definitions that are consistent with this specification should be adopted for the purposes of understanding the present techniques.

Although specific embodiments have been described above, these embodiments are not intended to limit the scope of the present disclosure, even where only a single embodiment is described with respect to a particular feature. Examples of features provided in the disclosure are intended to be illustrative rather than restrictive unless stated otherwise. The above description is intended to cover such alternatives, modifications, and equivalents as would be apparent to a person skilled in the art having the benefit of this disclosure.

The scope of the present disclosure includes any feature or combination of features disclosed herein (either explicitly or implicitly), or any generalization thereof, whether or not it mitigates any or all of the problems addressed herein. Various advantages of the present disclosure have been described herein, but embodiments may provide some, all, or none of such advantages, or may provide other advantages.

## Claims

1. A method of detecting a defect of a coating on a conductive substrate, comprising:
traversing a length of the conductive substrate with a holiday detector, wherein the holiday detector comprises a housing and a spark generator disposed in the housing;
inducing, via the spark generator and an electrode, an arc voltage at the defect of the coating on the conductive substrate;
detecting the arc voltage with a sensor associated with the holiday detector, thereby detecting the defect; and
recording with electronics of the holiday detector an electrode voltage of the electrode associated with the arc voltage.

2. The method of claim 1, wherein the electronics comprise a microprocessor and memory, and wherein the conductive substrate having the coating comprises a pipeline.

3. The method of claim 2, wherein the electronics comprise a signal conditioner, a multiplexer, a voltage regulator, an analog to digital converter, and a Global Positioning System (GPS) sensor.

4. The method of claim 1, comprising recording, with the electronics, internal temperature of the housing, GPS location, battery voltage, and voltage of a ground cable.

5. The method of claim 1, comprising:
recording, by the holiday detector, velocity of the traversing;
transmitting the velocity as recorded from the holiday detector to an external computer system.

6. The method of claim 1, comprising:
transmitting a value of the electrode voltage as recorded from the holiday detector to an external computer system; and
displaying data associated with the arc voltage on a graphical user interface of a display device of the holiday detector or of the external computer system, or both.

7. The method of claim 1, wherein the sensor is disposed in the housing.

8. The method of claim 1, wherein the electrode comprises a conductive coil situated on the coating during the traversing.

9. The method of claim 1, wherein the electrode comprises an electrode housing, wherein the sensor is disposed in the electrode housing, and wherein the conductive substrate comprises a conduit.

10. The method of claim 9, wherein the sensor comprises a plurality of sensors to detect the arc voltage.

11. The method of claim 10, wherein detecting the defect comprises detecting a longitudinal location of the defect along the conduit and a circumferential location of the defect around the conduit.

12. The method of claim 1, comprising:
incrementing, by the electronics, a counter in response to detecting the defect; and
pausing, by the electronics, the incrementing of the counter in response to the incrementing the counter for the defect; and
resuming, by the electronics, the incrementing of the counter for another defect of the coating in response to user input, wherein the another defect is at a different location than the defect.

13. A system to traverse a length of a conductive substrate to detect a defect of a coating on the conductive substrate, comprising:
a detector comprising a spark generator to induce an arc voltage via a conductive coil at the defect of the coating on the conductive substrate;
a wand to couple the detector to the conductive coil;
the conductive coil as an electrode;
a sensor to detect the arc voltage to detect the defect; and
electronics comprising a processor and memory to record detection of the defect in the memory.

14. The system of claim 13, wherein the electronics are disposed in a housing of the detector.

15. The system of claim 13, comprising a rotating coupling connecting the wand to the conductive coil.

16. The system of claim 13, wherein the conductive substrate having the coating comprises a conduit.

17. The system of claim 16, wherein the conductive coil is configured to be situated around a circumference of the conduit and be moved longitudinally along the conduit.

18. The system of claim 17, wherein the sensor comprises a plurality of sensors spaced apart in a housing along the conductive coil to detect the arc voltage to detect the defect.

19. The system of claim 18, wherein the electronics and the plurality of sensors are configured to determine a longitudinal location of the defect along the conduit and a circumferential location of the defect around the conduit.

20. The system of claim 13, wherein the electronics are configured to increment a counter in response to the detection of the defect by the system and pause incrementing of the counter until user input is received to resume incrementing of the counter for another defect of the coating.
